(19) Europäisches Patentamt
European Patent Office
Office européen des brevets

(11) **EP 2 165 209 B1**

(12) **EUROPÄISCHE PATENTSCHRIFT**

(45) Veröffentlichungstag und Bekanntmachung des Hinweises auf die Patenterteilung:
**12.09.2018 Patentblatt 2018/37**

(21) Anmeldenummer: **08774748.1**

(22) Anmeldetag: **04.07.2008**

(51) Int Cl.:
***G01R 31/36*** *(2006.01)*

(86) Internationale Anmeldenummer:
**PCT/EP2008/058636**

(87) Internationale Veröffentlichungsnummer:
**WO 2009/004075 (08.01.2009 Gazette 2009/02)**

(54) **VERFAHREN ZUR ERMITTLUNG DER RUHESPANNUNG EINES ELEKTROCHEMISCHEN ENERGIESPEICHERS**

METHOD FOR THE DETERMINATION OF THE OFF-LOAD VOLTAGE OF AN ELECTROCHEMICAL ENERGY STORE

PROCÉDÉ DE DÉTERMINATION DE LA TENSION DE REPOS D'UN ACCUMULATEUR D'ÉNERGIE ÉLECTROCHIMIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **05.07.2007 DE 102007031305**

(43) Veröffentlichungstag der Anmeldung:
**24.03.2010 Patentblatt 2010/12**

(73) Patentinhaber: **Robert Bosch GmbH**
**70442 Stuttgart (DE)**

(72) Erfinder:
• **SCHMUCKER, Clemens**
**71732 Tamm (DE)**
• **SCHOCH, Eberhard**
**70469 Stuttgart-Feuerbach (DE)**
• **ISKE, Burkhard**
**71272 Renningen-Malmsheim (DE)**

(56) Entgegenhaltungen:
**EP-A- 0 994 362     EP-A- 1 231 476**
**DE-A1- 10 128 033     DE-A1-102005 015 727**

**Beschreibung**

Die Erfindung betrifft ein Verfahren zur Ermittlung der Ruhespannung eines elektrochemischen Energiespeichers.

Stand der Technik

Die Ruhespannung eines elektrochemischen Energiespeichers, beispielsweise einer Blei-Säure-Batterie, ist eine wichtige Größe für die Bestimmung des Ladezustands des elektrochemischen Energiespeichers. Diese Ruhespannung stellt sich in Abhängigkeit von der Temperatur und der Vorgeschichte, beispielsweise einer Ladung oder einer Entladung des Energiespeichers, unterschiedlich schnell ein. Zu einer genauen Ermittlung der Ruhespannung ist stets eine Ruhezeit von mehr als 10 Stunden notwendig, in welcher der Batteriestrom 0 A beträgt.

Wird der Energiespeicher in einem Kraftfahrzeug verwendet, dann steht in den meisten Fällen weder die genannte Ruhezeit zur Verfügung noch ist der Batteriestrom vernachlässigbar klein.

Um dennoch in einem Kraftfahrzeug die Ruhespannung der Fahrzeugbatterie ermitteln zu können werden Verfahren verwendet, bei denen aus gemessenen Batteriespannungen und Batterieströmen während der Ruhephase auf die Ruhespannung der Batterie geschlossen wird, ohne dass vorher auf ein vollständiges Abklingen der Batteriespannung gewartet wird.

Aus der DE 10 2005 015 727 A1 ist ein Verfahren zur Ermittlung der Ruhespannung einer Speicherbatterie bekannt, bei welchem Betriebsparameter der Speicherbatterie in der Ruhephase bestimmt werden und bei welchem des Weiteren die Ruhespannung mittels einer in Abhängigkeit von den Betriebsparametern ausgewählten Ruhespannungsermittlungsroutine ermittelt wird. Als Betriebsparameter werden insbesondere die aktuelle Ruhezeit, der Ruhestrom und die Ladung der Deltakapazität der Speicherbatterie verwendet. Ruhespannungsermittlungsroutinen, die verwendet werden, sind eine Ermittlung der Ruhespannung mit einer die Polarisation der Speicherbatterie berücksichtigenden Routine, eine Ermittlung der Ruhespannung mit einer SOC-Nachführung über eine Stromintegration, eine Ermittlung der Ruhespannung unter Verwendung einer Extrapolation der Batteriespannung und einer Berücksichtigung der Polarisation der Speicherbatterie sowie eine Ermittlung der Ruhespannung unter Verwendung ausschließlich einer Extrapolation der Batteriespannung. Dabei wird der Verlauf der gemessenen Batteriespannungswerte genutzt und es erfolgt eine Extrapolation der gemessenen Batteriespannungswerte auf einen stationären Wert U00. Dieser Ruhespannungswert U00 gibt die Klemmenspannung bei 25°C, 0 A und unendlich langer Ruhezeit an. Da die gemessene Klemmenspannung der Batterie temperaturabhängig ist, wird nach der Extrapolation die Temperaturabhängigkeit der Ruhespannung kompensiert. Zusätzlich tritt im Falle eines Entladestroms eine Polarisationsspannung auf, die ebenfalls kompensiert wird.

Bei diesem bekannten Verfahren wird die genannte Kompensation der Ruhespannung bezüglich der Temperatur und des Ruhestromes (Polarisationsspannung) nach der Extrapolation der gemessenen Batteriespannungswerte auf den stationären Wert durchgeführt. Dies hat zur Folge, dass eine starke Temperaturänderung einer in Ruhe befindlichen Batterie eine Änderung der Klemmenspannung verursacht, die als Einschwingvorgang einer nicht in Ruhe befindlichen Batterie interpretiert wird. Die auf diese Weise ermittelte Ruhespannung ist demzufolge stark fehleranfällig bzw. fehlerbehaftet. Dasselbe gilt im Falle von Änderungen des Ruhestromes (Polarisationsspannung) und bei einer langsamen Entladung der Batterie. In all diesen Fällen kann eine Veränderung der Klemmenspannung entstehen, die fälschlicherweise als Einschwingvorgang interpretiert wird und Fehler verursachen kann. Diese Effekte treten auch bei einer nicht in Ruhe befindlichen Batterie auf und überlagern sich mit dem eigentlichen Einschwingvorgang.

Aus der EP-0994362 A ist bereits ein Verfahren zur Bestimmung des Ladezustandes und der Hochstrombelastbarkeit von Batterien bekannt. Hierzu werden in den stromlosen Pausen vor und nach einer Belastungsphase die Leerlaufspannungen gemessen. Daraus werden unter Berücksichtigung batteriespezifischer Parameter, insbesondere des zeitlichen Verlaufes der Leerlaufspannung, die echten Batterieruhespannungen berechnet. Während der Belastungsphase wird die umgesetzte Strommenge gemessen und die Säurekapazität des Akkumulators ermittelt.

Aus der DE-102005015727 A ist bereits ein Verfahren zur Ermittlung der Ruhespannung einer Speicherbatterie bekannt. Ein Bestimmen der Betriebsparameter der Speicherbatterie erfolgt in der Ruhephase. Die Ruhespannung wird jeweils in Abhängigkeit von den Betriebsparametern ausgewählten Ruhespannungsermittlungsroutine bestimmt.

Vorteile der Erfindung

Ein Verfahren mit den Merkmalen des Anspruchs 1 weist demgegenüber den Vorteil auf, dass es gegenüber Temperaturänderungen, Ruhestromänderungen und Ladungsentnahmen während der Ruhephase eines elektrochemischen Energiespeichers robuster ist. Insbesondere führt ein Verfahren gemäß der Erfindung zu einer Reduzierung der bei bekannten Verfahren entstehenden Fehler bei der Ruhespannungsermittlung. Erfindungsgemäß werden bei dem Verfahren nach Anspruch 1 während einer Ruhephase des elektrochemischen Energiespeichers zu vorgegebenen Zeitpunkten die Klemmenspannung des Energiespeichers, der durch den Energiespeicher fließende Strom und die Temperatur des Energiespeichers gemessen.

Diese Vorteile beruhen darauf, dass gemäß der vorliegenden Erfindung die Ruhespannung mittels eines Extrapolationsverfahrens unter Berücksichtigung von temperatur-, strom- und ladungskompensierten Spannungswerten ermittelt wird.

Anschließend erfolgt eine Normierung der genannten Klemmenspannung auf einen vorgegebenen Temperaturwert, eine Stromkompensation unter Berücksichtigung der Polarisationsspannung sowie eine Kompensation der Ladungsentnahmen während der Ruhephase.

Weitere vorteilhafte Eigenschaften der Erfindung ergeben sich aus deren beispielhafter Erläuterung anhand der Zeichnung.

Zeichnung

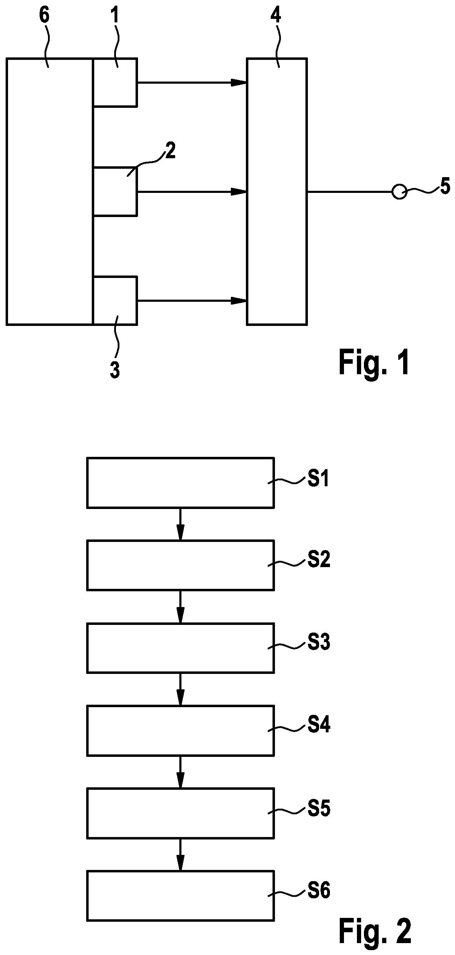

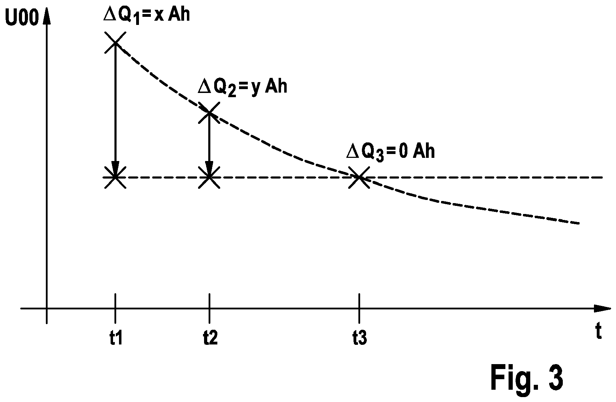

Die Figur 1 zeigt ein Blockdiagramm zur Erläuterung der zur Ermittlung der Ruhespannung eines elektrochemischen Energiespeichers benötigten Bauteile. Die Figur 2 zeigt ein Flussdiagramm zur Erläuterung eines Verfahrens zur Ermittlung der Ruhespannung eines elektrochemischen Energiespeichers. Die Figur 3 zeigt ein Diagramm zur Veranschaulichung der Kompensation der Ladungsentnahmen während der Ruhephase eines elektrochemischen Energiespeichers.

Beschreibung

Die Figur 1 zeigt ein Blockdiagramm zur Erläuterung der zur Ermittlung der Ruhespannung eines elektrochemischen Energiespeichers benötigen Bauteile. In diesem Blockdiagramm sind ein Spannungssensor 1, ein Stromsensor 2, ein Temperatursensor 3, eine Recheneinheit 4 mit einem Ausgangsanschluss 5 und ein elektrochemischer Energiespeicher 6 dargestellt. Bei dem elektrochemischen Energiespeicher 6 handelt es sich beispielsweise um eine Blei-Säure-Batterie. Der Spannungssensor 1 dient zur Messung der Klemmenspannung des elektrochemischen Energiespeichers 6, der Stromsensor 2 zur Messung des durch den elektrochemischen Energiespeicher 6 fließenden Stromes und der Temperatursensor 3 zur Messung der Temperatur des elektrochemischen Energiespeichers 6. Alle diese Messungen erfolgen während der Ruhephase des elektrochemischen Energiespeichers, d. h. bei ausgeschaltetem Motor, und werden in vorgegebenen zeitlichen Abständen wiederholt, beispielsweise in Abständen von einer Stunde.

Der gemessene Klemmenspannungswert, der gemessene Stromwert und der gemessene Temperaturwert werden der Recheneinheit 4 zugeführt und von dieser verarbeitet. Ziel dieser Verarbeitung ist eine Ermittlung der Ruhespannung des elektrochemischen Energiespeichers 6 mittels eines Extrapolationsverfahrens unter Berücksichtigung von temperatur-, strom- und ladungskompensierten Spannungswerten. Die von der Recheneinheit 4 ermittelte Ruhespannung wird am Ausgangsanschluss der Recheneinheit zur Verfügung gestellt und kann beispielsweise zur Bestimmung des Ladezustands des elektrochemischen Energiespeichers verwendet werden.

Die Figur 2 zeigt ein Flussdiagramm zur Erläuterung eines erfindungsgemäßen Verfahrens zur Ermittlung der Ruhespannung eines elektrochemischen Energiespeichers. Im Schritt S1 erfolgt eine Messung der Klemmenspannung des elektrochemischen Energiespeichers mittels des Spannungssensors 1. Die vom Spannungssensor 1 bereitgestellten Messsignale werden an die Recheneinheit 4 weitergegeben. Im Schritt S2 erfolgt eine Messung des durch den elektrochemischen Energiespeicher 6 fließenden Stromes mittels des Stromsensors 2. Die vom Stromsensor 2 bereitgestellten Messsignale werden an die Recheneinheit 4 weitergegeben. Im Schritt S3 erfolgt eine Messung der Temperatur des elektrochemischen Energiespeichers 6 mittels des Temperatursensors 3. Die vom Temperatursensor 3 bereitgestellten Messsignale werden an die Recheneinheit 4 weitergegeben.

Die Reihenfolge der Schritte S1, S2 und S3 ist beliebig. Beispielsweise kann alternativ zu dem vorstehend beschriebenen Ausführungsbeispiel auch zuerst eine Messung der Temperatur, dann eine Messung des Stromes und schließlich eine Messung der Klemmenspannung vorgenommen werden.

Nach den Schritten S1, S2 und S3 führt die Recheneinheit 4 anhand der ihr zugeführten Messwerte zunächst im Schritt S4 eine Normierung der gemessenen Klemmenspannung auf einen vorgegebenen Temperaturwert durch, der beispielsweise 25°C beträgt. Anschließend nimmt sie im Schritt S5 eine Stromkompensation vor, bei welcher der Entladestrom des elektrochemischen Energiespeichers unter Berücksichtigung der Polarisationsspannung des elektrochemischen Energiespeichers kompensiert wird. Schließlich kompensiert die Recheneinheit 4 im Schritt S6 im Rahmen einer Ladungskompensation in der Vergangenheit gemessene Klemmenspannungswerte um die Ladungsentnahmen bis zum aktuellen Zeitpunkt, so dass am Ausgang der Recheneinheit 4 ein Ruhespannungswert bereitgestellt wird, welcher mittels eines Extrapolationsvorganges unter Berücksichtigung von temperatur-, strom- und ladungskompensierten Spannungswerten ermittelt wurde.

Die im Schritt S4 genannte Normierung der gemessenen Klemmenspannung auf den vorgegebenen Temperaturwert von 25°C erfolgt gemäß der folgenden Beziehung:

$$\text{Ubatt\_25°C} = \text{Ubatt}-(\text{Tbatt} - 25°C) \bullet 1{,}38 \text{ mV/°C}.$$

Dabei ist Ubatt die gemessene Klemmenspannung und Tbatt die gemessene Batterietemperatur.

Die im Schritt S5 genannte Stromkompensation erfolgt unter Berücksichtigung der Polarisationsspannung. Bei der Bestimmung der Polarisationsspannung wird - wie es in der DE 10 2005 015 727 A1 beschrieben ist - zwischen geladener und entladener Deltakapazität des elektrochemischen Energiespeichers unterschieden. Zusätzlich zu den in der DE 10 2005 015 727 A1 genannten Größen werden in vorteilhafter Weise bei der Bestimmung der Polarisationsspannung die Batterienennkapazität und die Batteriealterung berücksichtigt. Darüber hinaus wird bei der vorliegenden Erfindung anstelle der in der DE 10 2005 015 727 A1 beschriebenen Vorgehensweise in vorteilhafter Weise beim Vorliegen einer entladenen Deltakapazität die Polarisationsspannung gemäß der folgenden Beziehung ermittelt, welche genauere Werte für die Polarisationsspannung liefert:

$$\text{Ubatt\_ 25°\_C\_0A}$$
$$= \text{Ubatt\_25°C}-(-0{,}0133) \bullet \exp(-0{,}04 \bullet \text{ Tbatt}) \bullet$$
$$\bullet \sqrt{\left(\lvert Ibatt \rvert \bullet 1000\right)} \bullet F1 \bullet F2 .$$

Dabei sind Ubatt_25°C die auf 25°C normierte Klemmenspannung, Tbatt die Temperatur des elektrochemischen Energiespeichers, Ibatt der durch den elektrochemischen Energiespeicher fließende Strom, F1 ein die Batterienennkapazität berücksichtigender Faktor und F2 ein die Batteriealterung berücksichtigender Faktor.

Die im Schritt S6 genannte Kompensation der Ladungsentnahme während der Ruhephase erfolgt durch eine Korrektur von in der Vergangenheit gemessenen Klemmenspannungen Ubatt(t_n) um die Ladungsentnahme bis zum jeweiligen Zeitpunkt t_n. Als weitere Größe wird bei dieser Kompensation die Batteriesäurekapazität CO verwendet. Diese Kompensation erfolgt gemäß der folgenden Beziehungen:

$$\text{Ubatt\_25C\_0A\_0Ah}(\text{t\_akt})$$
$$= \text{Ubatt\_25C\_0A\_0Ah}(\text{t\_akt} - 1) +$$
$$\text{Ibatt}(\text{t\_akt}) \bullet \Delta t(\text{t\_akt, t\_akt} - 1) / C0;$$

$$\text{Ubatt\_25C\_0A\_0Ah}(\text{t\_akt})$$
$$= \text{Ubatt\_25C\_0A\_0Ah}(\text{t\_akt} - 2) +$$
$$\text{Ibatt}(\text{t\_akt}) \bullet \Delta t(\text{t\_akt, t\_akt} - 1) / C0 +$$
$$\text{Ibatt}(\text{t\_akt} - 1) \bullet \Delta t(\text{t\_akt} - 1, \text{t\_akt} - 2) / C0;$$

$$\text{Ubatt\_25C\_0A\_0Ah}(\text{t\_akt})$$
$$= \text{Ubatt\_25C\_0A\_0Ah}(\text{t\_akt} - n) +$$
$$\text{Ibatt}(\text{t\_akt}) \bullet \Delta t(\text{t\_akt, t\_akt} - 1) / C0 + ... +$$
$$\text{Ibatt}(\text{t\_akt} - n + 1) \bullet \Delta t(\text{t\_akt} - n + 1, \text{t\_akt} - n) / C0.$$

Die Figur 3 zeigt ein Diagramm zur Veranschaulichung der Kompensation der Ladungsentnahmen während der Ruhephase eines elektrochemischen Energiespeichers. In diesem Diagramm ist längs der Abszisse die Zeit und längs der Ordinate die Ruhespannung U00 aufgetragen. Des Weiteren veranschaulicht in diesem Diagramm die gepunktete Linie den zeitlichen Verlauf der ermittelten Ruhespannung, wenn keine Kompensation der entnommenen Ladung vorgenommen wird, und die gestrichelte Linie den zeitlichen Verlauf der ermittelten Ruhespannung nach erfolgter Durchführung einer Kompensation der entnommenen Ladung. Ferner geht aus dem Diagramm hervor, dass zum Zeitpunkt t1 eine Ladungsentnahme $\Delta Q_1 = x$ Ah kompensiert wurde, zum Zeitpunkt t2 eine Ladungsentnahme $\Delta Q_2 = y$ Ah und dass sich zum Zeitpunkt t3 die beiden Spannungsverläufe schneiden, so dass die Ladungsentnahme $\Delta Q_3 = 0$ Ah beträgt.

Gemäß der vorliegenden Erfindung werden nach alledem zur Ermittlung der Ruhespannung nur kompensierte Spannungswerte Ubatt_25°C_0A_0Ah(t_n) verwendet. Auf diese Weise werden bei der Ruhespannungsermittlung alle Umgebungseinflüsse kompensiert und die Extrapolation auf eine stationäre Ruhespannung wird unabhängig von Änderungen in den Randbedingungen.

**Patentansprüche**

1.  Verfahren zur Ermittlung der Ruhespannung eines elektrochemischen Energiespeichers, bei welchem die Ruhespannung mittels eines Extrapolationsverfahrens unter Berücksichtigung von temperatur-, strom- und ladungskompensierten Spannungswerten ermittelt wird und bei welchem zur Ermittlung der Ruhespannung während einer Ruhephase des elektrochemischen Energiespeichers zu vorgegebenen Zeitpunkten (tn) die Klemmenspannung (Ubatt) des Energiespeichers, der durch den Energiespeicher fließende Strom (Ibatt) und die Temperatur (Tbatt) des Energiespeichers gemessen werden, wobei im Rahmen der Stromkompensation der Spannungswerte die Polarisationsspannung ermittelt wird, **dadurch gekennzeichnet, dass** bei der Ermittlung der Polarisationsspannung die Batterienennkapazität und die Batteriealterung berücksichtigt werden.

2.  Verfahren nach Anspruch 1, **dadurch gekennzeichnet, dass** die gemessene Klemmenspannung (Ubatt) auf einen vorgegebenen Temperaturwert normiert wird.

3.  Verfahren nach Anspruch 2, **dadurch gekennzeichnet, dass** der vorgegebene Temperaturwert 25°C beträgt.

4.  Verfahren nach Anspruch 3, **dadurch gekennzeichnet, dass** die Normierung der gemessenen Klemmenspannung (Ubatt) auf den vorgegebenen Temperaturwert gemäß der folgenden Beziehung vorgenommen wird:

$$\text{Ubatt\_25°C} = \text{Ubatt} - (\text{Tbatt} - 25°C) \bullet 1{,}38 \text{ mV/°C,}$$

wobei Ubatt_25°C die auf 25°C genormte gemessene Klemmenspannung, Ubatt die gemessene Batteriespannung und Tbatt die gemessene Batterietemperatur sind.

5.  Verfahren nach einem der vorhergehenden Ansprüche, **dadurch gekennzeichnet, dass** zur Ermittlung der Polarisationsspannung die Deltakapazität ermittelt und im Falle einer entladenen Deltakapazität die Polarisationsspannung gemäß der folgenden Beziehung ermittelt wird:

$$\text{Ubatt\_25°C\_0A} = \text{Ubatt\_25°C} - (-0{,}0133) \bullet \exp(-0{,}04 \bullet \text{Tbatt}) \bullet (|\text{Ibatt}| \bullet 1000)^{1/2} \bullet \text{F1} \bullet \text{F2,}$$

 wobei Ubatt_25°C_OA die Polarisationsspannung, Ubatt_25°C die normierte gemessene Klemmenspannung, Tbatt die gemessene Batterietemperatur, Ibatt der gemessene Batteriestrom, F1 ein von der Batterienennkapazität abhängiger Faktor und F2 ein von der Batteriealterung abhängiger Faktor sind.

6.  Verfahren nach einem der vorhergehenden Ansprüche, **dadurch gekennzeichnet, dass** im Rahmen der Ladungskompensation in der Vergangenheit gemessene Klemmenspannungswerte um die Ladungsentnahmen bis zum aktuellen Zeitpunkt korrigiert werden.

7.  Verfahren nach Anspruch 6, **dadurch gekennzeichnet, dass** im Rahmen der Ladungskompensation des Weiteren die Säurekapazität des Energiespeichers berücksichtigt wird.

8.  Verfahren nach Anspruch 7, **dadurch gekennzeichnet, dass** die Ruhespannung gemäß der folgenden Beziehung ermittelt wird:

$$\text{Ubatt\_25°C\_0A\_0Ah(t\_akt})$$
$$= \text{Ubatt\_25°C\_0A\_0Ah(t\_akt} - n) +$$
$$\text{Ibatt(t\_akt)} \bullet \Delta t \ (t\_akt, t\_akt \ \text{-}1) \ / \ \text{CO} + \ \dots +$$
$$\text{Ibatt(t\_akt} - n + 1) \bullet \Delta t \ (t\_akt - n + 1, t\_akt \ \text{-}n) \ / \ \text{CO,}$$

wobei Ubatt_25°C_0A_0Ah(t_akt) die ermittelte Ruhespannung und Ibatt der gemessene Batteriestrom sind.

**Claims**

1. Method for determining the quiescent voltage of an electrochemical energy store, wherein the quiescent voltage is determined by means of an extrapolation method taking account of temperature-, current- and charge-compensated voltage values and wherein for determining the quiescent voltage during a quiescent phase of the electrochemical energy store at predefined points in time (tn) the terminal voltage (Ubatt) of the energy store, the current (Ibatt) flowing through the energy store and the temperature (Tbatt) of the energy store are measured, wherein the polarisation voltage is determined in the context of the current compensation of the voltage values, **characterized in that** the battery rated capacity and the battery ageing are taken into account when determining the polarisation voltage.

2. Method according to Claim 1, **characterized in that** the measured terminal voltage (Ubatt) is normalised to a predefined temperature value.

3. Method according to Claim 2, **characterized in that** the predefined temperature value is 25°C.

4. Method according to Claim 3, **characterized in that** the normalisation of the measured terminal voltage (Ubatt) to the predefined temperature value is carried out in accordance with the following relationship:

$$\texttt{Ubatt\_25°C = Ubatt - (Tbatt - 25°C)} \bullet \texttt{1.38 mV/°C,}$$

wherein Ubatt_25°C is the measured terminal voltage normalised to 25°C, Ubatt is the measured battery voltage and Tbatt is the measured battery temperature.

5. Method according to any of the preceding claims, **characterized in that** for determining the polarisation voltage the delta capacity is determined and, in the case of a discharged delta capacity, the polarisation voltage is determined in accordance with the following relationship:

$$\texttt{Ubatt\_25°C\_0A = Ubatt\_25°C - (-0.0133)} \bullet \texttt{exp(-0.04} \bullet \texttt{Tbatt)}$$
$$\bullet \texttt{(|Ibatt|} \bullet \texttt{1000)}^{1/2} \bullet \texttt{F1} \bullet \texttt{F2,}$$

wherein Ubatt_25°C_0A is the polarisation voltage, Ubatt_25°C is the normalised measured terminal voltage, Tbatt is the measured battery temperature, Ibatt is the measured battery current, F1 is a factor dependent on the battery rated capacity, and F2 is a factor dependent on the battery ageing.

6. Method according to any of the preceding claims, **characterized in that** terminal voltage values measured in the past in the context of the charge compensation are corrected by the amounts of charge drawn up to the present point in time.

7. Method according to Claim 6, **characterized in that** the acid capacity of the energy store is furthermore taken into account in the context of the charge compensation.

8. Method according to Claim 7, **characterized in that** the quiescent voltage is determined in accordance with the following relationship:

$$\text{Ubatt\_25°C\_0A\_0Ah(t\_pres)} = \text{Ubatt\_25°C\_0A\_0Ah(t\_pres - n)} +$$
$$\text{Ibatt(t\_pres)} \bullet \Delta\text{t(t\_pres, t\_pres-1)/CO} + \ldots +$$
$$\text{Ibatt(t\_pres - n + 1)} \bullet \Delta\text{t(t\_pres -n + 1, t\_pres - n)/CO,}$$

wherein Ubat_25°C_0A_OAh (t_pres) is the quiescent voltage determined and Ibatt is the measured battery current.

**Revendications**

1. Procédé de détermination de la tension de repos d'un accumulateur d'énergie électrochimique, selon lequel la tension de repos est déterminée au moyen d'un procédé d'extrapolation en tenant compte de valeurs de tension compensées en température, en courant et en charge, et selon lequel, en vue de déterminer la tension de repos, la tension aux bornes (Ubatt) de l'accumulateur d'énergie, le courant (Ibatt) qui circule à travers l'accumulateur d'énergie et la température (Tbatt) de l'accumulateur d'énergie sont mesurés à des instants (tn) prédéfinis pendant une phase de repos de l'accumulateur d'énergie électrochimique, la tension de polarisation étant mesurée dans le cadre de la compensation en courant des valeurs de tension, **caractérisé en ce que** la capacité nominale de la batterie et le vieillissement de la batterie sont pris en considération lors de la détermination de la tension de polarisation.

2. Procédé selon la revendication 1, **caractérisé en ce que** la tension aux bornes (Ubatt) mesurée est normalisée à une valeur de température prédéfinie.

3. Procédé selon la revendication 2, **caractérisé en ce que** la valeur de température prédéfinie est de 25 °C.

4. Procédé selon la revendication 3, **caractérisé en ce que** la normalisation de la tension aux bornes (Ubatt) mesurée à la valeur de température prédéfinie est effectuée conformément à l'équation ci-après :

$$\text{Ubatt\_25 °C} = \text{Ubatt} - (\text{Tbatt} - 25 °C) \bullet 1,38 \text{ mV/°C,}$$

Ubatt_25 °C désignant la tension aux bornes mesurée normalisée à 25°C, Ubatt la tension de batterie mesurée et Tbatt la température de batterie mesurée.

5. Procédé selon l'une des revendications précédentes, **caractérisé en ce que** le delta de capacité est déterminé en vue de déterminer la tension de polarisation et, dans le cas d'un delta de capacité déchargé, la tension de polarisation est déterminée conformément à l'équation ci-après :

$$\text{Ubatt\_25 °C\_0A} = \text{Ubatt\_25 °C} - (-0,0133) \bullet \exp(-0,04 \bullet$$
$$\text{Tbatt)} \bullet (|\text{Ibatt}| \bullet 1000)^{\frac{1}{2}} \bullet \text{F1} \bullet \text{F2,}$$

Ubatt_25 °C_0A désignant la tension de polarisation, Ubatt_25 °C la tension aux bornes mesurée normalisée, Tbatt la température de batterie mesurée, Ibatt le courant de batterie mesuré, F1 un facteur dépendant de la capacité nominale de la batterie et F2 un facteur dépendant du vieillissement de la batterie.

6. Procédé selon l'une des revendications précédentes, **caractérisé en ce que** dans le cadre de la compensation de charge, les valeurs de la tension aux bornes mesurées dans le passé sont compensées en fonction des prélèvements de charge jusqu'à l'instant actuel.

7. Procédé selon la revendication 6, **caractérisé en ce que** dans le cadre de la compensation de charge, la capacité acide de l'accumulateur d'énergie est en outre prise en considération.

8. Procédé selon la revendication 7, **caractérisé en ce que** la tension de repos est déterminée conformément à l'équation ci-après :

$$Ubatt\_25 \text{ °C\_0A\_0Ah}(t\_akt) = Ubatt\_25 \text{ °C\_0A\_0Ah}(t\_akt-n)$$
$$+ \quad Ibatt(t\_akt) \quad \bullet \quad \Delta t(t\_atk, \quad t\_akt \ -1)/CO \quad + \quad \dots \quad +$$
$$Ibatt(t\_akt-n+1) \bullet \Delta t(t\_atk-n+1, \ t\_akt-n)/CO,$$

Ubatt_25 °C_0A_0Ah(t_akt) désignant la tension de repos déterminée et Ibatt le courant de batterie mesuré.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005015727 A1
- EP 0994362 A

- DE 102005015727 A